# EUROPEAN PATENT APPLICATION

(11) **EP 4 404 456 A1**
(43) Date of publication of application: **24.07.2024**
(21) Application number: 23152140.2
(22) Date of filing: 18.01.2023
(51) Int. Cl.: H02P 29/024, H02P 29/66

(54) **ELECTRO-MECHANICAL SYSTEM COMPRISING AT LEAST ONE ELECTRICAL MACHINE AND METHOD FOR DETECTING A STATOR WINDING FAULT**

(71) Applicant: Siemens Gamesa Renewable Energy A/S, 7330 Brande (DK)
(72) Inventor: Freire, Nuno Miguel Amaral, 7330 Brande (DK); Simeonov, Orlin Borisov, 7100 Vejle (DK); Soerensen, Morten Stier, 8700 Horsens (DK)
(74) Representative: SGRE-Association

(57) **Abstract**

Electro-mechanical system comprising at least one electrical machine (3), the electrical machine (3) comprising a stator (4) with at least one stator winding (5) and a rotor (7), wherein the rotor (7) comprises at least one temperature sensor (8, 9) arranged at a distance from a rotational axis (11) of the rotor (7), wherein the electro-mechanical system (1) comprises a monitoring device (12) designed to monitor the operation of the electrical machine (3), wherein in at least one mode of operation of the electro-mechanical system (1) the monitoring device (12) evaluates a fault condition (39), wherein a fulfilment of the fault condition (39) indicates a fault, especially a stator insulation fault, of the stator winding (5) or at least one of the stator windings (5), wherein the fulfilment of the fault condition (39) depends on temperature values (34) acquired during at least one rotation of the rotor (7) by the temperature sensor (8, 9), wherein multiple of the temperature values (34) are acquired at different times during each individual rotation of the rotor (7) in the at least one mode of operation.

## Description

The invention concerns an electro-mechanical system comprising at least one electrical machine, the electrical machine comprising a stator with at least one stator winding and a rotor. Additionally, the invention concerns a method for detecting a stator winding fault in the winding of a stator of an electrical machine.

During the operation of an electrical machine, the stator insulation of a stator winding can become damaged, e.g., due to wear and tear. In powerful electrical machines, e.g., in the generator of a wind turbine, a resulting short circuit can lead to a strong local heating that can damage components, e.g., demagnetize magnets, or even cause a fire. It is therefore highly relevant to detect winding faults, especially in-terturn short-circuit faults, in a stator winding as early as possible to avoid further damage to the electrical machine.

The document EP 3 879 282 A1 discloses an approach for an early detection of an insulation failure in electric generators. Current flowing in the electrical circuit is measured by current sensors and the measured currents are used to calculate parameters depending on an impedance of at least a portion of the electrical circuit to determine the state of the insulation. While this approach can allow for an early detection of failures, it can be desirable to use a more direct approach to detect critical errors that lead to a strong local heating.

The document EP 3 922 843 A1 suggests to use at least two temperature sensing elements at different positions of the power generation assembly of a wind turbine to detect an overheating of the generator. It is suggested to use temperature sensors at the phase connectors of a stator winding, the hottest point of the generator and possibly at further positions. While this approach could in principle be used to detect winding faults in a stator of an electrical machine, a robust detection of winding faults would require a rather large number of temperature sensors to ensure that each relevant part of the winding has a temperature sensor arranged closed to it.

The purpose of the present invention is therefore to allow for a detection of winding faults in the windings of a stator of an electrical machine that can be implemented with a lower technical complexity.

The problem is solved by an electro-mechanical system comprising at least one electrical machine, the electrical machine comprising a stator with at least one stator winding and a rotor, wherein the rotor comprises at least one temperature sensor arranged at a distance from a rotational axis of the rotor, wherein the electro-mechanical system comprises a monitoring device designed to monitor the operation of the electrical machine, wherein in at least one mode of operation of the electro-mechanical system the monitoring device evaluates a fault condition, wherein a fulfilment of the fault condition indicates a fault, especially a stator insulation fault, of the stator winding or at least one of the stator windings, wherein the fulfilment of the fault condition depends on temperature values acquired during at least one rotation of the rotor by the temperature sensor, wherein multiple of the temperature values are acquired at different times during each individual rotation of the rotor in the at least one mode of operation.

A faulty stator winding, especially a stator insulation fault, will typically lead to a strong local heating of the stator in a radial position close to the air gap between the stator and the rotor. As such a local heating could in principle be detected with temperature sensors mounted to the stator. In this case it would however be necessary to place a multitude of temperature sensors along the circumference of the stator.

The electro-mechanical system according the present invention therefore uses at least one temperature sensor that is attached to the rotor and arranged at a distance from a rotational axis of the rotor. When the rotor is rotating, the temperature sensor is therefore essentially scanning along the rotor-facing surface of the stator and therefore the use of a single temperature sensor is sufficient to detect winding faults in a given axial section of the stator.

When a winding fault leads to a local heating of an area of the stator, the distance between the temperature sensor of the rotor and the heated area changes over time during each rotation of the rotor due to the off-axis arrangement of the temperature sensor. Therefore, the measured temperature value will oscillate synchronously with the rotation of the rotor. Such an oscillation of a measured temperature value with the rotation angle and therefore over time can be easily and robustly detected, therefore allowing a detection of a stator winding fault with a low number of components and a low implementation complexity.

In principle it would be sufficient to determine a measure for the variation of the temperature values during a single or multiple rotations, e.g., the difference between the maximum temperature and the minimum temperature, and/or to determine statistical properties of the temperature values like, e.g., a standard deviation or a variance, of the temperature values and to determine if the fault condition is fulfilled based on this difference or the standard deviation or variance or a similar measure.

It was however found that an even more robust determination is possible when temperature values are determined for multiple rotations, especially at an essentially constant rotational speed. The speed can be considered to be essentially constant when the variation of the rotational speed is lower than 5 % or 10 %.

The variation of the temperature values over time due to the varying distance between the temperature sensor and the area heated due to the winding fault will lead to an approximately periodic signal due to the winding fault. Therefore, the presence of a signal with a known, fixed frequency can be detected. This allows for several approaches for improving the signal-to-noise ratio and therefore the robustness of the fault detection. For example, a band-pass filtering, a Fourier-analysis and/or lock-in-techniques can be used.

When the fault condition is fulfilled, the monitoring device can modify the control of the electro-mechanical system, e.g., to brake the electrical machine to a standstill, or send a signal to a control device to perform such a control. Additionally or alternatively, a signal can be sent to a further device when the fault condition is fulfilled, e.g. to a central control unit of a wind park, a mobile communication device of service personal or a server of a service company, etc.

The evaluation of the fault condition can be performed approximately in real time during the operation of the electrical machine, to allow the performance of counter measures when a winding fault is detected to avoid damaging further components. Additionally or alternatively, the evaluation of the fault condition and/or in general an analysis of the acquired temperature values can be performed offline at a later point in time, e.g. to analyze the temporal development of the fault and its effects.

The fulfilment of the fault condition can depend on the amplitude of a frequency component of a sequence of the acquired temperature values. It is especially possible that the fault condition is fulfilled or can only be fulfilled, when the amplitude is larger or equal than a given threshold value. The amplitude can be directly determined using, e.g., Fourier-analysis or a lock-in-technique. It is however also possible, to, e.g., use bandpass filtering, especially in the digital domain, and, e.g., an envelope follower or a rectification and lowpass filtering of the bandpass filtered signal to determine the amplitude.

Preferably, the temperature values are determined periodically at a fix frequency in the at least one mode of operation. At a fixed rotational speed, the sampling frequency corresponds to a fixed angular frequency and the relevant frequency component can easily be determined based on the rotational speed. When the rotational speed changes and/or when the same frequency component should be analyzed even at different rotational speeds, adaptive band-pass filters or other signal processing techniques used.

As an alternative to using a fixed temporal frequency for the acquisition of the temperature values, it would also be possible to acquire temperature values at fixed rotational angles of the rotor. The frequency component is an angular frequency component in this case and the analyzed frequency component can especially be the angular frequency of 1/360°, therefore detecting events that happen once per rotation.

In the at least one mode of operation of the electro-mechanical system the monitoring device can determine the rotational speed of the rotor and/or control the electrical machine and/or at least one further component of the electro-mechanical system to adjust the actual rotational speed of the rotor to a given rotational speed, wherein the frequency component is chosen based on the determined and/or given rotational speed. Preferably, the frequency component is centered around the rotational frequency of the rotor. In principle it would also be possible to analyze amplitudes of harmonics of the rotational frequency of the rotor, since the temperature oscillation due to the local heating is not a perfect sine wave. The centering of the frequency component around the rotational speed is however advantageous, since the existence of a single winding fault and therefore a single area of local heating typically leads to the strongest signal at this fundamental frequency.

In a preferred embodiment, exactly one temperature sensor arranged at a single axial end of the rotor or a magnet of the rotor or exactly two temperature sensors arranged at different axial ends of the rotor or the magnet or different magnets of the rotor is or are used to determine the temperature values. An arrangement at the axial end of the rotor can especially consist of an arrangement of the respective temperature sensor in the final 10 % or 5 % of the rotor length and/or an arrangement in the area of the end windings of the stator can be chosen.

The use of a single temperature sensor at a single end of the rotor and/or in the area of a single end winding, especially at the drive end facing the hub when the electrical machine is part of a wind turbine, can be advantageous, since such a temperature sensor is in many cases used anyway in generators to supervise the temperatures of the magnets in the rotor. Such a temperature sensor can, e.g., be used to limit the current in the stator windings and/or the rotational speed to avoid an overheating and therefore a demagnetization of the magnets. In such cases the electro-mechanical system according to the present invention and/or the method according to the present invention discussed later can be implemented with very minor variations of such an existing electro-mechanical system, e.g., by adding an additional monitoring device or by modifying an existing monitoring device, in the simplest case by a software update. The electro-mechanical system and the method according to the present invention can therefore be implemented with very low technical complexity and there is a simple update path for many existing electro-mechanical systems.

The use of exactly two temperature sensors arranged at different axial ends of the rotor to determine the temperature values can be advantageous, since such an arrangement allows for a very robust detection of winding faults in both end windings of the stator. It was found that most winding faults that appear during the normal operation of an electrical machine are winding faults in the end windings. At the same time the use of only two temperature sensors still allows for an implementation of the invention with low effort and complexity.

In an alternative embodiment it would also be possible to use multiple temperature sensors distributed along the length of the rotor to provide temperature values for multiple axial sections of the electrical machine. This can allow for a more robust detection of winding faults outside of the end windings of the stator and a more precise localization of the winding fault. In most use cases, the use of exactly two temperature sensors does however provide the best compromise between the robustness and precision of the fault detection and localization and the required effort for implementing the invention.

Preferably, the electro-mechanical system comprises a positional sensor for determining the angular position of the rotor and/or a point in time at which the rotor reaches a given rotational angle, wherein the monitoring device determines an angular position of the fault based on the or a sequence of the acquired temperature values and the respective angular position acquired at the time of the acquisition of at least one of the temperature values and/or at least one time during the sequence at which the given rotational angle is reached. The use of such a positional sensor allows for a localization of the area of local heating and therefore of the winding fault in the circumferential direction of the stator, since the angular position of the maximum temperature value or preferably of a maximum of the temperature sequence determined from the temperature values can be determined. When relatively low sampling rates are used to determine the temperature values, a more precise angular position can, e.g., be determined by using interpolation or by considering the phase of the analyzed angular frequency component to determine a position of a temperature maximum between sampled temperature values.

The monitoring device and/or a control device of the electro-mechanical system can be designed to control the electrical machine and/or at least one further component of the electro-mechanical system to reduce the rotational speed from an initial value to a lower final value when a trigger condition is met, wherein the rotational speed is kept at or below the final value by the monitoring device and/or the control device in the first mode of operation.

In other words, the rotational speed can be reduced below an initial value, that is especially used during the normal operation of the electro-mechanical system, e.g., to generate power in a wind turbine. By keeping the rotational speed at or below the final value during the first mode of operation, a more detailed mapping of the temperature distribution along the circumference of the stator can be described by the temperature values, even when a temperature sensor with a relatively low bandwidth and/or a relatively larger sampling interval between the temperature values is used.

In a direct drive wind turbine, the initial value could, e.g., be in the range of two to sixteen revolutions per minute or generally in a range of rotational speeds that is used to provide the rated power to an electric grid. The operation at the initial rotational speed can continue until thermal stability is reached, which can be the or one of the possible trigger conditions. The rotation can then be slowed down, e.g., to an idle stop at which the generator rotates at a fraction of the rated speed, e.g., below two revolutions per minute.

At such slow speeds, even a thermal sensor with a relatively low bandwidth can be used to robustly detect and preferably locate the winding fault. Even when a relatively high sampling rate for the temperature values and a high bandwidth for the temperature sensor is used, it can still be advantageous to use the slower final value for the rotational speed during the first mode of operation, since the influence of the thermal inertia of the temperature sensor itself and the surrounding components on the measurement can be reduced in this case, which can result in a better signal-to-noise ratio during the fault detection. A sufficiently robust fault detection can in general be achieved, when the product of the used number of revolutions per minute and the number of stator winding slots is smaller than half of the number of temperature samples that are acquired per minute.

It is possible, that the trigger condition can only be fulfilled, once the electrical machine is operating for a given minimum time at or above a given speed and/or when additional temperature values from at least one additional temperature sensor indicate a stable temperature distribution within the electrical machine and/or when an alarm signal is provided by a smoke detector of the electro-mechanical system and/or when an electrical signal, especially a power provided by the electrical machine, is within a given value range. During the start-up of an electrical machine, the stator temperature along the air gap can vary quite strongly, which could lead to a false fault detection when oscillations of temperature values due to the rotation of the rotor are evaluated to detect a fault of the stator winding. This problem can be avoided when using a minimum operational time prior the acquisition of the temperature values. Since the time necessary to reach thermal equilibrium can, e.g., depend on ambient temperatures and other operational parameters of the electrical machine, it can however be advantageous to evaluate the additional temperature value to detect an equilibrium state of the electrical machine more robustly.

In the simplest case, the trigger condition can evaluate, if the additional temperature value reaches or exceeds a given threshold value indicating a sufficient warmup time for the electrical machine to reach thermal equilibrium. Additionally or alternatively, it is however also possible to compare additional temperature values provided by multiple additional temperature sensors. In this case the trigger condition can, e.g., be only fulfilled when the difference between the additional temperature values provided by the additional temperature sensors is below a given threshold value, indicating thermal equilibrium. Alternatively or additionally, the trigger condition can be evaluated by a separate monitoring system, e.g. based on electrical signals.

The fulfilment of the fault condition and/or a sending of a fault signal to an internal component of the electro-mechanical system and/or an external device when the fault condition is fulfilled and/or a modification of the operation of the electro-mechanical system when the fault condition is fulfilled can depend on at least one additional information, the respective additional information indicating whether power is provided by the electrical machine to an electric grid and/or an operational state of a cooling system of the electrical machine and/or an amount of power currently provided to or by the electrical machine.

Various cases in which fault signals can be sent to an internal component or an external device and/or in which the operation of the electro-mechanical system can be modified when the fault condition is fulfilled were already discussed above. In the simplest case, one or multiple of these steps can be directly taken, when the fault condition is fulfilled. In this case, the fault condition can optionally depend on the at least one additional information discussed above. The additional information can then, e.g., be used to only perform a fault detection when no power is provided to the electric grid and/or when the cooling system of the electrical machine is operational and/or when no or only very little power is provided to and/or by the electrical machine. This condition can, e.g., be equivalent to the previously discussed idle stop, during which the generator of a wind turbine is running at a relatively low speed while pivoting no power to the electric grid and while the cooling system is operational to improve the thermal equilibrium.

In some use cases it can be advantageous to potentially trigger multiple actions when the fault condition is fulfilled. In this case it can be advantageous, when the fault condition is independent from at least one of the mentioned additional pieces of information and when this additional piece of information is only used to limit the sending of a signal and/or the change of the operation of the system to cases, in which the fault is detected in specific situations.

The electro-mechanical system can comprise the or a cooling system for actively cooling the stator and/or the rotor of the electrical machine, wherein the cooling system is active during the first mode of operation. The use of the cooling system in the first mode of operation can allow for a more stable temperature at the surface of the stator facing the air gap, when there is no winding fault present, and therefore can improve the detection and localization of a winding fault.

The temperature sensor can be a thermistor or a film platinum resistance temperature sensor or a fiber optics temperature sensor. Additionally or alternatively, the temperature sensor can have a bandwidth of preferably at least 10 Hz or at least 20 Hz. The discussed sensor designs are especially useful to achieve a high bandwidth of the temperature sensor. A higher bandwidth of the temperature sensor allows for the evaluation of the fault condition at higher rotational speeds of the rotor and/or allows for a stronger variation of the temperature values, especially of a larger amplitude of the frequency component, at a given rotational speed, therefore leading to an improved signal-to-noise ratio and a more robust detection of the fault of the stator winding. With a sufficiently high sample rate and sensor bandwidth it can, e.g., be possible to use the normal power generation of a generator of the wind turbine as the at least one mode of operation. Therefore, the fault detection can optionally be used without a limitation of the rotational speed.

A thermal conducting means, especially a thermal paste, can be arranged radially between the stator and the rotor, at least partially filling the air gap between the stator and the rotor. Since the invention uses a temperature sensor arranged on the rotor to detect changes of the local stator temperature, the amplitude of the change of the temperature values due to a fault of a winding is limited by the low thermal conductivity of the air in the air gap. By using a smaller air gap or by at least partially filling the air gap using thermal conducting means with a good thermal conductivity, the change of the temperature values due to the presence of a fault in the stator winding and therefore especially the amplitude of the frequency component can be increased, therefore allowing for an improved signal-to-noise ratio for the measurement and an improved robustness of the fault detection.

Known thermal conductive properties of the medium, e.g., of the airgap, can be used to determine a delay caused by the heat conduction from the insulation fault or in general from the stator to the rotor, to, e.g., compensate for errors in the determined position of a detected fault due to this delay.

When a sufficient sensitivity is achieved, e.g., by using high bandwidth sensors and in the case of a reasonably high thermal conductivity across the air gap, even faults of the stator winding leading to a relatively low temperature increase can be detected. It can possible in this case to detect a weakening of the stator insulation prior to a complete failing of the stator insulation that leads to a short circuit.

The electro-mechanical system can be a wind turbine, wherein the electrical machine forms the generator of the wind turbine. Alternatively, the electro-mechanical system can comprise multiple wind turbines, wherein each of the wind turbine uses at least one of the electrical machines as a generator. As previously discussed, the detection of faults in stator windings is highly relevant in the area of wind turbines. At the same time the generators in wind turbines use relatively low rotational speeds, therefore allowing for a high robustness of the fault detection using the described approach. When the electro-mechanical system comprises multiple wind turbines, a common monitoring device can be used to evaluate temperature values provided by each of the wind turbines. The common monitoring device can, e.g., be integrated into one of the wind turbines or it can be arranged separately from all wind turbines, e.g., in a control center of a wind park.

Besides the electro-mechanical system, the invention also concerns a method for detecting a stator winding fault in the winding of a stator of an electrical machine, wherein the electrical machine comprises a stator with at least one stator winding and a rotor, wherein a fault condition is evaluated, wherein a fulfilment of the fault condition indicates the fault, especially a stator insulation fault, of the stator winding or at least one of the stator windings, wherein the fulfilment of the fault condition depends on temperature values acquired during at least one rotation of the rotor by the temperature sensor, wherein multiple of the temperature values are acquired at different times during each individual rotation of the rotor. The inventive method can especially be implemented using the electro-mechanical system according to the present invention. Independent of the use of the electro-mechanical system according to the present invention, features discussed with respect to the electro-mechanical system according to the present invention can be transferred to the method according to the present invention with the advantages given above and vice versa.

Other objects and features of the present invention will become apparent from the following detailed description considered in conjunction with the accompanying drawings. The drawings, however, are only principle sketches designed solely for the purpose of illustration and do not limit the invention. The drawings show:
- Fig. 1: an exemplary embodiment of an electro-mechanical system according to the present invention,
- Fig. 2: a flow-chart of an exemplary embodiment of a method for detecting a stator winding fault according to the present invention, and
- Fig. 3: exemplary measurement values used in the method according to fig. 2 to detect and locate a winding fault.

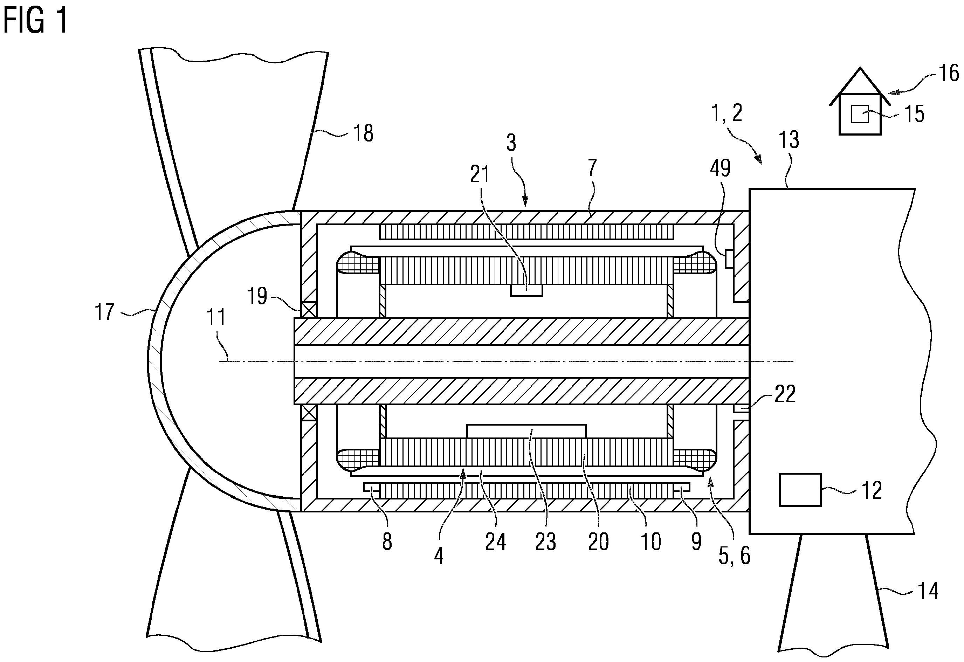

Fig. 1 shows an electro-mechanical system 1 comprising an electrical machine 3. In the example the electro-mechanical system 1 is a wind turbine 2 with a local monitoring device 12 that monitors the operation of the electrical machine 3 and controls the electrical machine 3, e.g., the current fed to the stator windings 5, and further components 18, in the example the blades of the wind turbine mounted to the hub 17. Specifically, the monitoring device 12 is designed to detect the presence of faults in the stator windings 5. Alternatively or additionally, an external monitoring device 15 could be used for this purpose, that could, e.g., be located in a control center 16 of a wind park comprising multiple wind turbines 2 to supervise the electrical machines 3 of these wind turbines 2.

The exemplary wind turbine 2 comprises a nacelle 13 mounted on top of a tower 14 and a stator 4 mounted to the nacelle 13. The wind turbine 2 is a direct drive wind turbine 2 and the rotor 7 is therefore directly mounted to the hub 17. The rotor 7 is rotatably mounted around the stator 4 by the bearing 19.

The rotor 7 comprises two temperature sensors 8, 9, each one mounted on an axial end of a magnet 10 of the rotor 7. The temperature sensors 8, 9 are offset with respect to the rotational axis 11 of the rotor and travel along the outer circumference of the stator 4 or more specifically the end windings 6 of the winding 5 of the stator 4 when the rotor is rotating. If the winding 5 comprises a winding fault, especially in one of the end windings 6, the temperature at the respective temperature sensor 8, 9 will be temporarily increased while the respective temperature sensor 8, 9 passes the area heated by the winding fault.

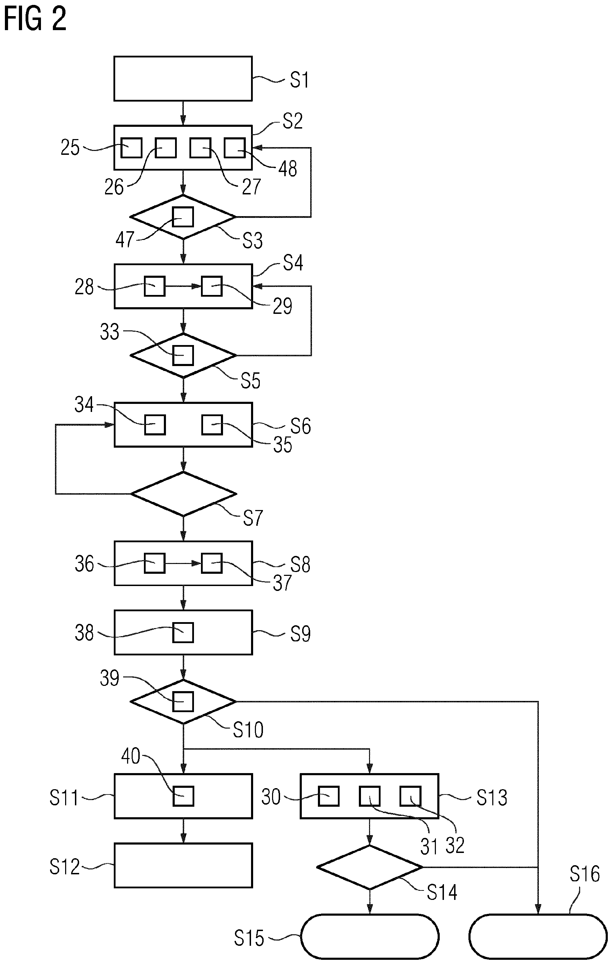

This feature is used by the monitoring device 12 to detect such a winding fault. An exemplary method used for this purpose will now be discussed with additional reference to fig. 2.

In general, the method, that will be discussed in more detail later, evaluates a fault condition 39, wherein a fulfilment of the fault condition indicates a fault, especially a stator insulation fault, of the stator winding 5 or at least one of the stator windings 5. The fulfilment of the fault condition 39 depends on previously recorded temperature values that are acquired during multiple rotations of the rotor, wherein multiple of the temperature values 34 are acquired at different times during each individual rotation of the rotor 7.

The flow chart in fig. 2 assumes that the wind turbine 2 is at a standstill at the beginning of the method. In step S1 the normal starting procedure of the wind turbine 2 is initiated by the monitoring device 12, e.g., by opening brakes (not shown), adjusting the angle of the wind turbine blades forming the further components 18 and by connecting the generator formed by the electrical machine 3 to the grid once a sufficient rotational speed is reached. Immediately at the start up or after a certain operational time, the cooling system 23 for actively cooling the stator 4 can also be activated.

In step S2 various operational parameters of the electrical machine 3 are recorded, namely the time 25 for which the wind turbine 2 is operating at or above a given rotor speed and the current rotational speed 26. Optionally a temperature value 27 can be recorded by the temperature sensor 21. Additionally or alternatively, at least one electrical signal, in the example the power 48 currently provided by the generator, can be acquired.

These values are then used to evaluate a trigger condition 47 in step S3. The trigger condition 47 can especially be fulfilled, once pre-defined operating conditions are reached, e.g., given values or value ranges for the rotational speed 26, the temperature, the power 48 and/or the operational time 25. Additionally other inputs, e.g., signals from a smoke detector 49 and/or signals indicating a calibration requirement, can be evaluated by the trigger condition 47.

The trigger condition 47 can, e.g., be fulfilled, when the time 25, the speed 26 and the temperature value 27 exceed a respective threshold. Additionally or alternatively, a temperature difference between a temperature value recorded via the temperature sensors 8, 9 and the temperature value recorded by the temperature sensor 21 can be compared to a further threshold value as part of the trigger condition 47, since this temperature differential is a measure for the thermal equilibrium within the electrical machine 3.

While the trigger condition 47 is not fulfilled, the operation of the wind turbine 2 continuous with a normal operational speed, especially feeding current to the power grid.

When the trigger condition 47 is fulfilled in step S3, it can be assumed that testing for stator insulation faults can commence. For this purpose, the monitoring device 12 controls the electrical machine 3 and other components 18, especially the turbine blades, to reduce the rotational speed 26 of the rotor 7 from an initial value 28 to a lower final value 29, e.g., to a single rotation every 2 to 4 minutes. As already discussed in detail in the general part of the description, lower rotational speeds can lower the influence of the thermal inertia of the temperature sensors 8, 9 and attached components, e.g., the magnet 10, on the measured temperature values 34 and can therefore allow for a more robust measurement.

In step S5 it is checked, if the rotational speed 26 has reached the final value 29 and therefore the mode 33 of operation for detecting faults of stator windings 5 is reached. If this is not the case, the lowering of the rotational speed 26 is continued by repeating step S4. When the operation mode 33 is reached in step S5, in step S6 a respective temperature value 34 is acquired by each of the temperature sensors 8, 9 and at the same time the angular position 35 of the rotor 3 is acquired using the positional sensor 22.

The previous discussion assumes, that it is necessary or at least desirable to slow down the rotation of the rotor 7 prior to the fault detection. In these cases, it can be advantageous to limit the fault detection to specific circumstances, e.g., a prior alarm of a smoke detector 49 or a startup of the wind turbine 2, to limit the amount of time during which the rotational speed is lowered. Alternatively, a slowdown of the rotor 7 can be avoided and therefore steps S3 and step S4 can be skipped, when a sufficiently high sample rate and bandwidth of the temperature sensors 8, 9 is used, as already discussed in the general part of the description.

In step S7 it is checked, if the acquisition of the temperature values 34 and the angular positions 35 was already performed for a given number of revolutions of the rotor 3. If this is not the case, step S6 is repeated. The acquisition of the temperature values 34 and the angular positions 35 is preferably repeated with a fixed periodicity and therefore with a fixed sample rate.

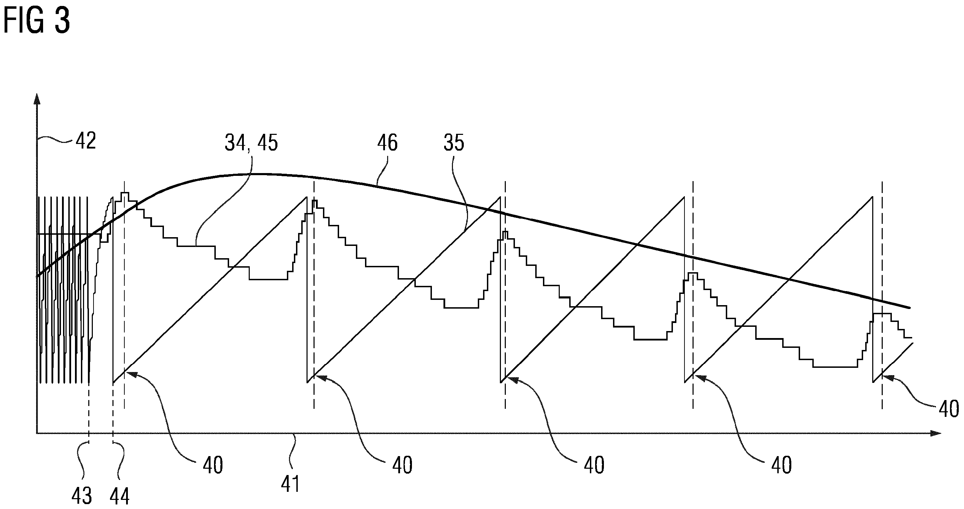

Once the measurements in step S6 are performed for the given number of revolutions, an average rotational speed 36 is determined in step S8 and used select a matching frequency component 37 from the sequence 45 of temperature values 34 shown in fig. 3.

For a better understanding of this step and the previous preparatory steps the following discussion will additionally refer to exemplary measurement data shown in fig. 3. In the diagram shown in fig. 3 the x-axis 41 shows the progression of time and the y-axis 42 shows different values for the different curves shown in the figure. The curve with the approximate saw tooth shape shows the change of the angular position 35 over time. Until the time 43, at which the trigger condition 47 is fulfilled, the angular position oscillates rather fast, corresponding to a relatively large angular velocity of the rotor 3. Once the trigger condition 47 is fulfilled, the rotation slows down as indicated by the reduced slope of the angular position 35 between the times 43 and 44. At the time 44, the mode 33 of operation is reached and the rotational speed and therefore the rate of change of the angular position 35 stays approximately constant.

The sequence 45 of the temperature values 34 shows that the temperature values 34 are approximately constant while the rotor 7 is rotating relatively fast due to the limited bandwidth and the thermal inertia of the temperature sensors 8, 9. Once the lower rotational speed is reached, the sequence 45 of the temperature values 34 of the temperature sensors 8, 9 show a distinct oscillation with the same frequency as the frequency of the rotation of the rotor 7, if a winding fault is present in the end winding 6 as shown in fig. 3.

Overall, the temperature values 34 in the sequence 45 fall over time once the rotational speed of the rotor 7 is reduced, since lower currents are induced into the stator windings 5 at lower rotational speeds and therefore a lower amount of heat is produced by the winding fault. To further illustrate this effect, the line 46 shows the temperature of the stator body 20 of the stator 4 at a position relatively close to the winding 5.

It should be noted that the line 46 and the sequence 45 are represented at different scales. The line 46 is spanning the temperature range of approximately 15 °C, while the range of the temperature values 34 is limited to a range of approximately 5 °C.

Due to the relatively small temperature changes at the temperature sensors 8, 9, it is advantageous to apply further processing to the sequence 45 instead of, e.g., simply taking the difference value between the maximum value and the minimum value during a single rotation as a measure for the presence of a fault.

In the example in step S8 a frequency component 37 of the sequence 45 is extracted by applying a bandpass filter, wherein the center frequency of the bandpass filter matches the average rotational speed 36.

Alternatively, the frequency component 37 could, e.g., be extract using a Fourier transform of the sequence 45 or by lock-in techniques. The extraction of the frequency component 37 eliminates or at least suppresses on the one hand a low frequency component due to the drift of the temperature to lower temperatures due to the lowered heating at lower rotor speeds discussed above and on the other hand high frequency quantization noise introduced by the resolution limit of the temperature sensors 8, 9. The pseudo-periodicity of the sequence 45 is therefore used to improve the signal-to-noise ratio.

In step S9 an amplitude 38 of the frequency component is determined. When bandpass filtering is used, as discussed above, the amplitude can, e.g., be determined by rectifying the frequency component 37 and low-pass filtering or averaging the resulting signal. If a Fourier transform or a lock-in-amplification is used, the amplitude 38 is directly provided.

In step S10 a fault condition 39 is evaluated. In the present example, the fault condition 39 simply compares the amplitude 38 with a given threshold value. If the threshold value is exceeded for the temperature values 34 provided by one of the temperature sensors 8, 9, it is assumed that a fault is present in the end winding 6 or close to the end winding 6 at the respective end of the stator 4.

If the fault condition 39 is not fulfilled, normal operation of the electro-mechanical system 1 is resumed in step S16. In the case of the wind turbine 2, the rotational speed of the rotor 7 is increased back to normal rotational speeds and power is once again provided to the power grid.

If on the other hand the fault condition 39 is fulfilled in step S10, an angular position 40 of the fault is determined in step 511. The angular position 40 of the fault is indicated by vertical lines positioned at the local maxima of the oscillating sequence 45 in fig. 3. Since the angular position 35 for each temperature value 34 is explicitly recorded, the angular position 40 of the maximum can be directly read out.

The angular position 40 and additional information concerning the detected fault can then be signaled to an outside device in step S12, e.g., to the control center 16 of the wind park, a mobile device of service personal, etc.

In many cases it is also advantageous to shut down the operation of the wind turbine 2 once the fault condition 39 is fulfilled. Depending on the sensitivity of the fault detection, it can however be possible that the fault condition 39 is already fulfilled when the short-circuit has not yet occurred.

Therefore, additional information 30, 31, 32 can be recorded in step S13 and it can be decided in step S14 if the additional information 30, 31, 32 and the amplitude 38 indicate a required shutdown, in which case in the monitoring device 12 can control the electrical machine 3 and the further components 18 to stop the wind turbine 2 in step S15. Otherwise, the operation can normally continue in step S16.

In the example, the additional information 30 concerns an information whether the electrical machine 3 is connected an electrical grid, the additional information 31 concerns the operational state of a cooling system 23, and the additional information 32 can concern the amount of power provided to or by the electrical machine 3. The use of the discussed additional information 30 - 32 can, e.g., allow to continue to provide power at a lower value to the power grid, only if the fault condition 39 indicates an insulation degradation without the occurrence of a fault and/or if the generator is designed to be fault tolerant, e.g., allowing for an operation within safe operational limits in the presence of an inter-turn short-circuit fault.

The use of temperature sensors 8, 9 mounted to the rotor 7 to detect winding faults of a stator winding 5 has the advantage of only requiring a single temperature sensor 8, 9 to sample the full circumference of the stator 4. As already discussed with reference to fig. 3, the presence of an air gap between the stator 4 and the temperature sensors 8, 9 does however noticeably lower the amplitude of the measured temperature oscillations when a winding fault is present. Returning to fig. 1, it is therefore advantageous that a conducting means 24, especially a thermal paste, is used to partially fill the air gap and therefore improve the thermal coupling of the temperature sensors 8, 9 to the windings 5.

Although the present invention has been described in detail with reference to the preferred embodiment, the present invention is not limited by the disclosed examples from which the skilled person is able to derive other variations without departing from the scope of the invention.

## Claims

1. Electro-mechanical system comprising at least one electrical machine (3), the electrical machine (3) comprising a stator (4) with at least one stator winding (5) and a rotor (7), **characterized in that** the rotor (7) comprises at least one temperature sensor (8, 9) arranged at a distance from a rotational axis (11) of the rotor (7), wherein the electro-mechanical system (1) comprises a monitoring device (12) designed to monitor the operation of the electrical machine (3), wherein in at least one mode of operation of the electro-mechanical system (1) the monitoring device (12) evaluates a fault condition (39), wherein a fulfilment of the fault condition (39) indicates a fault, especially a stator insulation fault, of the stator winding (5) or at least one of the stator windings (5), wherein the fulfilment of the fault condition (39) depends on temperature values (34) acquired during at least one rotation of the rotor (7) by the temperature sensor (8, 9), wherein multiple of the temperature values (34) are acquired at different times during each individual rotation of the rotor (7) in the at least one mode of operation.

2. Electro-mechanical system according to claim 1, **characterized in that** the fulfilment of the fault condition (39) depends on the amplitude (38) of a frequency component (37) of a sequence (45) of the acquired temperature values (34).

3. Electro-mechanical system according to claim 1 or 2, **characterized in** the in the at least one mode of operation of the electro-mechanical system (1) the monitoring device (12) determines the rotational speed (36) of the rotor (7) and/or controls the electrical machine (3) and/or at least one further component of the electro-mechanical system (1) to adjust the actual rotational speed (36) of the rotor (7) to a given rotational speed (36), wherein the frequency component (37) is chosen based on the determined and/or given rotational speed (36) .

4. Electro-mechanical system according to one of the preceding claims, **characterized in that** exactly one temperature sensor (8, 9) arranged at a single axial end of the rotor (7) or a magnet (10) of the rotor (7) or exactly two temperature sensors (8, 9) arranged at different axial ends of the rotor (7) or the magnet (10) or different magnets (10) of the rotor (7) is or are used to determine the temperature values (34).

5. Electro-mechanical system according to one of the preceding claims, **characterized in that** it comprises a positional sensor (22) for determining the angular position (35) of the rotor (7) and/or a point in time at which the rotor (7) reaches a given rotational angle, wherein the monitoring device (12, 15) determines an angular position (40) of the fault based on the or a sequence (45) of the acquired temperature values (34) and the respective angular position (35) acquired at the time of the acquisition of at least one of the temperature values (34) and/or at least one time during the sequence (45), at which the given rotational angle is reached.

6. Electro-mechanical system according to one of the preceding claims, **characterized in that** the monitoring device (12, 15) and/or a control device of the electro-mechanical system (1) is designed to control the electrical machine (3) and/or at least one further component (18) of the electro-mechanical system (1) to reduce the rotational speed (26) from an initial value (28) to a lower final value (29) when a trigger condition (47) is met, wherein the rotational speed (26) is kept at or below the final value (29) by the monitoring device (12, 15) and/or the control device in the first mode (33) of operation.

7. Electro-mechanical system according to claim 6, **characterized in that** the trigger condition (47) can only be fulfilled, once the electrical machine (3) is operating for a given minimum time (25) at or above a given speed (26) and/or when additional temperature values (27) from at least one additional temperature sensor (21) indicate a stable temperature distribution within the electrical machine (3) and/or when an alarm signal is provided by a smoke detector (49) of the electro-mechanical system (1) and/or when an electrical signal, especially a power (48) provided by the electrical machine (3), is within a given value range.

8. Electro-mechanical system according to one of the preceding claims, **characterized in that** the fulfilment of the fault condition (39) and/or a sending of a fault signal to an internal component of the electro-mechanical system (1) and/or an external device when the fault condition (39) is fulfilled and/or a modification of the operation of the electro-mechanical system (1) when the fault condition (39) is fulfilled depends on at least one additional information (30-32), the respective additional information (30-32) indicating whether power is provided by the electrical machine (3) to an electric grid and/or an operational state of a cooling system (23) for the electrical machine (3) and/or an amount of power currently provided to or by the electrical machine (3) .

9. Electro-mechanical system according to one of the preceding claims, **characterized in that** it comprises the or a cooling system (23) for actively cooling the stator (4) and/or the rotor (7) of the electrical machine (3), wherein the cooling system (23) is active during the first mode (33) of operation.

10. Electro-mechanical system according to one of the preceding claims, **characterized in that** the temperature sensor (8, 9) is a thermistor or a film platinum resistance temperature sensor or a fiber optics temperature sensor and/or **in that** the temperature sensor (8, 9) has a bandwidth of at least 10 Hz or at least 20 Hz.

11. Electro-mechanical system according to one of the preceding claims, **characterized in that** a thermal conducting means (24), especially a thermal paste, is arranged radially between the stator (4) and the rotor (7), at least partially filling the air gap between the stator (4) and the rotor (7).

12. Electro-mechanical system according to one of the preceding claims, **characterized in that** electrical system (1) is a wind turbine (2), wherein the electrical machine (3) forms the generator of the wind turbine (2), or **in that** the electro-mechanical system (1) comprises multiple wind turbines (2), wherein each of the wind turbines (2) uses at least one of the electrical machines (3) as a generator.

13. Method for detecting a stator winding fault in the winding (5) of a stator (4) of an electrical machine (3), wherein the electrical machine (3) comprises a stator (4) with at least one stator winding (5) and a rotor (7), **characterized in that** the rotor (7) comprises at least one temperature sensor (8, 9) arranged at a distance from a rotational axis (11) of the rotor (7), wherein a fault condition (39) is evaluated, wherein a fulfilment of the fault condition (39) indicates the fault, especially a stator insulation fault, of the stator winding (5) or at least one of the stator windings (5), wherein the fulfilment of the fault condition (39) depends on temperature values (36) acquired during at least one rotation of the rotor (7) by the temperature sensor (8, 9), wherein multiple of the temperature values (36) are acquired at different times during each individual rotation of the rotor (7).
